# EUROPÄISCHE PATENTANMELDUNG

(11) **EP 3 514 125 A1**
(43) Veröffentlichungstag der Anmeldung: **24.07.2019**
(21) Anmeldenummer: 18152112.1
(22) Anmeldetag: 17.01.2018
(51) Int. Cl.: C04B 35/80, C04B 35/628, C04B 35/117, C04B 35/14, C23C 16/34, C23C 16/40, F01D 5/28

(54) **FASERVERBUNDWERKSTOFF MIT KERAMISCHEN FASERN, BAUTEIL, GASTURBINE UND VERFAHREN**

(71) Anmelder: Siemens Aktiengesellschaft, 80333 München (DE)
(72) Erfinder: Heinrichsdorff, Frank, 14513 Teltow (DE); Jensen, Jens Dahl, 14050 Berlin (DE); Schneider, Manuela, 13581 Berlin (DE); Winkler, Gabriele, 13587 Berlin (DE)

(57) **Zusammenfassung**

Faserverbundwerkstoff mit keramischen Fasern, Bauteil, Gasturbine und Verfahren

Die Erfindung betrifft einen Faserverbundwerkstoff (1) mit keramischen Fasern (2) und einer keramischen Matrix (3), in welche die Fasern (2) eingebettet sind, wobei zwischen den jeweiligen Fasern (2) und der Matrix (3) eine jeweilige Gleitschicht (4) angeordnet ist. Um eine verbesserte mechanische und/oder thermische Belastbarkeit zu realisieren, ist vorgesehen, dass die jeweilige Gleitschicht (4) mittels Atomlagenabscheidung an der jeweiligen Faser (2) angeordnet ist.

## Beschreibung

Die Erfindung betrifft einen Faserverbundwerkstoff mit keramischen Fasern und einer keramischen Matrix gemäß dem Oberbegriff von Patentanspruch 1. Des Weiteren betrifft die Erfindung ein Bauteil, welches zumindest aus einem solchen Faserverbundwerkstoff gebildet ist, eine Gasturbine mit wenigstens einem solchen Bauteil und ein Verfahren zum Herstellen des Faserverbundwerkstoffs.

In Hochtemperaturanwendungen können keramische Faserverbundwerkstoffe verglichen mit Metalllegierungen vorteilhaft sein, da sie eine größere thermische Belastbarkeit aufweisen. Beispielsweise können Metalllegierungen häufig nur bis circa 850°C eingesetzt werden. Aus diesem Grund sind im Rahmen solcher Hochtemperaturanwendungen Bauteile zumindest teilweise aus keramischen Werkstoffen gefertigt, die den thermischen Belastungen besser standhalten können als Metalllegierungen.

Nachteilig ist jedoch, dass keramische Werkstoffe üblicherweise spröde sind und bei Temperaturschocks, also rapiden Temperaturveränderungen, zu Rissbildungen neigen. Um diesen Rissbildungen entgegenzuwirken, werden keramische Faserverbundwerkstoffe eingesetzt, welche Temperaturstabilität, hohe Zugfestigkeit und Sauerstoffunempfindlichkeit in sich vereinen. Beispielhafte Faserverbundwerkstoffe sind Mullit-Fasern in einer Matrix aus Aluminiumoxid, Siliziumdioxid oder einer Mischung aus beidem. Die mechanischen Eigenschaften des keramischen Faserverbundwerkstoffs hängen im Besonderen von der Ausgestaltung einer Grenzfläche zwischen Faser und Matrix ab. Ist die Verbindung zwischen Fasern und Matrix zu spröde beziehungsweise zu starr, können bei Rissbildungen in der Matrix dennoch die Fasern durchtrennt werden.

Um diese Rissbildung an den Fasern zu vermeiden, ist die Matrix zumindest partiell, insbesondere um die Fasern herum, stark porös ausgeführt. Beispielsweise kann die Porosität der Matrix 40 bis 60 Volumenprozent betragen. Die poröse Matrix ist dazu ausgebildet, Risse im Faserverbundwerkstoff aufzunehmen und so einer Belastung der Fasern entgegenzuwirken. Insbesondere wird hierdurch eine gleichmäßigere Krafteinleitung in die Fasern ermöglicht. Diese Vorgehensweise wird häufig mit dem englischen Fachbegriff "Weak Matrix Concept", zu Deutsch "schwaches Matrixkonzept" bezeichnet. Die poröse Matrix beziehungsweise das Weak Matrix Concept besitzt den Nachteil, dass die mechanische Belastbarkeit des Faserverbundwerkstoffs im Vergleich zu Metalllegierungen stark eingeschränkt ist. Außerdem verliert der Faserverbundwerkstoff seinen duktilen Charakter und damit sein schadenstolerantes Deformationsverhalten.

Beispiele für Hochtemperaturanwendungen, in welchen derartige Faserverbundwerkstoffe eingesetzt werden, sind Gasturbinen, Hitzeschilde an Raumfähren, Verbrennungsmotoren sowie Abgassysteme, insbesondere Turbolader. Dabei wird der Faserverbundwerkstoff häufig als Wärmedämmschicht beziehungsweise Hitzeschild zum Schutz einer Metalllegierung vor thermischer Belastung eingesetzt. Beispielsweise werden Bauteile mit einem Trägerkörper aus einer Metalllegierung mit dem Faserverbundwerkstoff als Wärmedämmung beziehungsweise Hitzeschild überzogen. Vorteilhaft kann weiterhin die Kombination mehrerer Wärmedämmschichten aus unterschiedlichen keramischen Materialien sein.

Es ist Aufgabe der vorliegenden Erfindung, einen Faserverbundwerkstoff zu schaffen, der verbesserte mechanische und/oder thermische Belastbarkeit aufweist.

Diese Aufgabe wird erfindungsgemäß gelöst durch die Gegenstände der unabhängigen Patentansprüche. Vorteilhafte Ausführungsformen mit zweckmäßigen Weiterbildungen sind Gegenstand der Unteransprüche.

Ein erster Aspekt der vorliegenden Erfindung betrifft einen Faserverbundwerkstoff mit keramischen Fasern und einer keramischen Matrix, in welche die Fasern eingebettet sind, wobei zwischen der jeweiligen Faser und der Matrix eine jeweilige Gleitschicht angeordnet ist. Dabei sind die keramischen Fasern insbesondere dazu ausgebildet, den Faserverbundwerkstoff gegenüber Zugkräften längs zur Erstreckungsrichtung der Fasern zu stabilisieren. Die Fasern können in jeweiligen Lagen angeordnet sein. Zur Stabilisierung des Faserverbundwerkstoffs in unterschiedliche Raumrichtungen können jeweilige Fasern unterschiedlicher Erstreckungsrichtung in dem Faserverbundwerkstoff angeordnet sein. Hauptaufgabe der Matrix kann es sein, die Krafteinleitung in den Faserverbundwerkstoff vorzunehmen und die Fasern zu stabilisieren.

Durch die jeweilige Gleitschicht kann sichergestellt sein, dass es zu einem Gleiten zwischen Faser und Matrix kommt, bevor eine Belastung für die Faser eine kritische Grenze überschreitet, was zu einer Zerstörung der Faser führen würde. Mit anderen Worten ist durch das Gleiten zumindest teilweise eine Relativbewegung zwischen Faser und Matrix, insbesondere längs zur Erstreckungsrichtung der jeweiligen Faser, möglich. Die Wahrscheinlichkeit des Reißens einer Faser kann auf die Weise gesenkt werden. Außerdem kann durch das Gleiten eine gleichmäßigere Krafteinleitung in den Faserverbundwerkstoff beziehungsweise eine Verteilung einer Kraft auf mehrere Fasern gewährleistet sein. Dieses Konzept kann analog zu dem Weak Matrix Concept auch als "Weak Interface Concept", zu Deutsch "Konzept der schwachen Bindung" bezeichnet werden.

Um nun einen Faserverbundwerkstoff zu schaffen, der eine verbesserte mechanische und/oder thermische Belastbarkeit aufweist, ist erfindungsgemäß vorgesehen, dass die jeweilige Gleitschicht mittels Atomlagenabscheidung an der jeweiligen Faser angeordnet beziehungsweise auf die jeweilige Faser aufgebracht ist. Mit anderen Worten ist die jeweilige Faser durch Atomlagenabscheidung mit der Gleitschicht versehen beziehungsweise beschichtet. Eine derartig aufgebrachte Gleitschicht zeichnet sich einerseits durch eine besonders geringe Dicke aus, insbesondere im Bereich weniger Atomlagen. Beispielsweise beträgt die Dicke der Gleitschicht weniger als 200, 100, 50 oder 20 Atomlagen. Durch die geringe Dicke der Gleitschicht kann ein Gleitverhalten der Fasern in der Matrix verbessert werden. Außerdem zeichnet sich die mittels Atomlagenabscheidung an der jeweiligen Faser angeordnete Gleitschicht durch eine besonders homogene und defektarme Struktur aus. Dadurch wird eine zusätzliche Verbesserung der Gleiteigenschaften der Fasern relativ zur Matrix erzielt.

Insbesondere ist an jeder der Fasern eine jeweilige Gleitschicht angeordnet. Somit weist jede der Fasern eine jeweilige mittels Atomlagenabscheidung an der jeweiligen Faser angeordnete beziehungsweise auf die jeweilige Faser aufgebrachte Gleitschicht auf. Eine jeweilige Oberfläche einer jeweiligen Faser ist insbesondere vollständig durch Atomlagenabscheidung mit der Gleitschicht überzogen.

Vorteilhafterweise ist zwischen der jeweiligen Gleitschicht und der Matrix zusätzlich eine jeweilige Diffusionssperre angeordnet. Mit anderen Worten ist die jeweilige Gleitschicht der jeweiligen Faser mit der Diffusionssperre versehen beziehungsweise beschichtet. Vorzugsweise ist eine jeweilige Oberfläche der jeweiligen Gleitschicht vollständig mit der Gleitschicht versehen beziehungsweise beschichtet. Die Diffusionssperre ist vorteilhafterweise dazu ausgebildet, das Eindringen von Reagenzien zu vermeiden, welche für die Fasern und/oder die Gleitschichten schädlich sein können. Insbesondere kann die Diffusionssperre das Eindringen von Sauerstoff vermeiden. Daher kann die Diffusionssperre auch als Oxidationsschutz bezeichnet werden.

Gemäß einer Weiterbildung ist vorgesehen, dass die Diffusionssperre mittels Atomlagenabscheidung auf die Gleitschicht aufgebracht ist. Mit anderen Worten ist die Gleitschicht durch Atomlagenabscheidung mit der Diffusionssperre versehen beziehungsweise beschichtet. Daraus ergibt sich für die Diffusionssperre einerseits der Vorteil der geringen Schichtdicke und andererseits der Vorteil der besonders homogenen und defektarmen Struktur. Insbesondere weist die Diffusionssperre eine Dicke von nur wenigen Atomlagen, beispielsweise weniger als 200, 100, 50 oder 20 Atomlagen auf. Durch die homogene und defektarme Struktur kann die Diffusion von schädlichen Reagenzien, insbesondere Sauerstoff, besonders gut vermieden werden.

Die Diffusionssperre ist vorteilhafterweise zumindest aus Aluminiumoxid (Al₂O₃) gebildet. Mit anderen Worten kann die Diffusionssperre durch eine Schicht aus Aluminiumoxid und optional weiterer Materialien bereitgestellt sein. In manchen Ausführungsformen ist die Diffusionssperre ausschließlich aus Aluminiumoxid gebildet.

An dieser Stelle sei kurz darauf verwiesen, dass unabhängige Aspekte der Erfindung bereitgestellt sind durch einen Faserverbundwerkstoff mit keramischen Fasern und einer keramischen Matrix, in welche die Fasern eingebettet sind, wobei zwischen den Fasern und der Matrix eine jeweilige Gleitschicht angeordnet ist und wobei eine Diffusionssperre nach einer der oben genannten Ausführungsformen an der jeweiligen Faser ist. Mit anderen Worten stellen Faserverbundwerkstoffe, welche eines oder mehrere der vorhergehend oder nachfolgend offenbarten Merkmale für die Diffusionssperre aufweisen, jeweils eigenständige und unabhängige Aspekte der vorliegenden Erfindung, auch ohne das Merkmal, das die jeweilige Gleitschicht mittels Atomlagenabscheidung an der jeweiligen Faser angeordnet ist.

Vorteilhafterweise ist die Gleitschicht zumindest aus Bornitrid (BN) gebildet. Mit anderen Worten kann die Gleitschicht aus Bornitrid oder optionalerweise weiteren Materialien gebildet sein. Als besonders vorteilhaft hat sich hierbei hexagonales Bornitrid erwiesen. Aus diesem Grund sieht eine Weiterbildung vor, dass die Gleitschicht zumindest aus hexagonalem Bornitrid gebildet ist. Mit anderen Worten weist die Gleitschicht zumindest einen Anteil an hexagonalem Bornitrid in ihrer Materialzusammensetzung auf. Vorteilhafterweise ist die Gleitschicht zumindest im Wesentlichen oder gar vollständig aus hexagonalem Bornitrid gebildet. Hexagonales Bornitrid weist besonders gute Gleiteigenschaften auf.

Eine Weiterbildung sieht vor, dass die Fasern zumindest aus Mullit gefertigt sind. Mit anderen Worten weist eine Materialzusammensetzung der Fasern zumindest einen Anteil an Mullit auf. Vorteilhafterweise sind die Fasern zumindest im Wesentlichen oder gar vollständig aus Mullit gebildet. Fasern aus Mullit weisen eine besonders hohe thermische und mechanische Belastbarkeit auf. Insbesondere weisen Fasern aus Mullit eine besonders hohe Bruchfestigkeit auf.

Eine Weiterbildung sieht vor, dass die Matrix aus Siliziumdioxid(Si₂O₂) und/oder Aluminiumdioxid (Al₂O₃) gebildet ist. Mit anderen Worten kann eine Materialzusammensetzung der Matrix zumindest einen Anteil an Siliziumdioxid und/oder Aluminiumdioxid aufweisen. Beispielsweise handelt es sich bei der Materialzusammensetzung der Matrix um eine Mischung aus Siliziumdioxid und Aluminiumoxid. Alternativ kann die Matrix zumindest im Wesentlichen oder ausschließlich aus Aluminiumdioxid oder Siliziumdioxid gefertigt sein. Siliziumdioxid und Aluminiumdioxid weisen jeweils eine besonders hohe thermische Belastbarkeit auf. Eine Matrix aus Aluminiumdioxid ist im Vergleich zu einer Matrix aus Siliziumdioxid zusätzlich besonders kostengünstig zu fertigen.

Eine Weiterbildung sieht vor, dass zwischen der jeweiligen Faser und der Matrix abwechselnd mehrere Gleitschichten und mehrere Diffusionssperren angeordnet sind. In diesem Fall handelt es sich bei der vorherigen und nachfolgend beschriebenen Gleitschicht um eine der mehrere Gleitschichten, wobei die übrigen der mehreren Gleitschichten gleichartig ausgeführt sind. Bei der zuvor und nachfolgend erläuterten Diffusionssperre handelt es sich um eine der mehreren Diffusionssperren, wobei die mehreren Diffusionssperren allesamt gleichartig ausgeführt sind. Jede der Fasern weist somit mehrere nacheinander beziehungsweise abwechselnd angeordnete Gleitschichten und Diffusionssperren auf. Mit anderen Worten befinden sich zwischen jeder der Fasern und der Matrix jeweils abwechselnd mehrere Gleitschichten und mehrere Diffusionssperren. Auf diese Weise können die Gleiteigenschaften der Faser und hierdurch die mechanische Belastbarkeit des Faserverbundwerkstoffs weiter verbessert werden. Außerdem bleiben die positiven Effekte der Gleitschicht und der Diffusionssperre auch dann aufrecht erhalten, wenn einzelne der mehreren Gleitschichten und/oder einzelne der mehreren Diffusionssperren versagen. Dieser Schichtaufbau mit mehreren Gleitschichten und mehreren Diffusionssperren wird erst durch die dünnen und kontrollierbaren Schichtdicken aufgrund der Atomlagenabscheidung ermöglicht.

Ein zweiter Aspekt der Erfindung betrifft ein Bauteil, welches zumindest aus dem im Vorherigen und im Nachfolgenden beschriebenen Faserverbundwerkstoff gebildet ist. Mit anderen Worten kann das Bauteil entweder ausschließlich aus dem Faserverbundwerkstoff oder aus dem Faserverbundwerkstoff und zumindest einem weiteren von dem Faserverbundwerkstoff unterschiedlichen Werkstoff gebildet sein. Aufgrund der Verwendung des Faserverbundwerkstoffs zeichnet sich das Bauteil durch eine hohe mechanische und/oder thermische Belastbarkeit aus. Somit ist das Bauteil insbesondere für Hochtemperaturanwendungen geeignet. Beispiele hierfür sind Gasturbinen, Hitzeschilde an Raumfähren, Verbrennungsmotoren sowie Abgassysteme, insbesondere Turbolader.

In weiterer Ausgestaltung kann das Bauteil wenigstens einen Trägerkörper aufweisen, welcher zumindest teilweise mit dem Faserverbundwerkstoff als Hitzeschild versehen ist. Beispielsweise ist der Faserverbundwerkstoff an einem thermisch und/oder mechanisch besonders stark belasteten Teil der Oberfläche des Trägerkörpers angeordnet. Mit anderen Worten kann der Trägerkörper vollständig oder teilweise, insbesondere an dem thermisch und/oder mechanisch besonders stark belasteten Teilen der Oberfläche, mit dem Faserverbundwerkstoff überzogen beziehungsweise durch den Faserverbundwerkstoff versiegelt sein. Da der erfindungsgemäße Faserverbundwerkstoff im Vergleich zu dem von dem Faserverbundwerkstoff unterschiedlichen Werkstoff eine besonders hohe thermische Belastbarkeit aufweisen kann, ergibt sich hierdurch eine Funktion als Hitzeschild. Der Faserverbundwerkstoff kann alternativ oder zusätzlich zu seiner hohen thermischen Belastbarkeit im Vergleich zu dem unterschiedlichen Werkstoff auch eine besonders hohe chemische Resistenz gegenüber Reagenzien, Prozessgasen, Verbrennungsprodukten oder Wasser aufweisen. In diesem Fall kann der Trägerkörper durch den Faserverbundwerkstoff vor chemischen Prozessen, Oxidation oder Korrosion geschützt sein.

Eine Weiterbildung sieht vor, dass der Trägerkörper aus einem von dem Faserverbundwerkstoff unterschiedlichen Werkstoff, insbesondere aus einem metallischen Werkstoff, gebildet ist. Auf diese Weise können thermische und mechanische Eigenschaften des Faserverbundwerkstoffs und des von diesem unterschiedlichen Werkstoffs besonders gut kombiniert sein. Beispielsweise weist der unterschiedliche Werkstoff eine höhere mechanische Festigkeit oder Belastbarkeit auf. Dies trifft insbesondere auf metallische Werkstoffe, insbesondere Legierungen, bevorzugt sogenannte Superlegierungen, zu.

Ein dritter Aspekt der Erfindung betrifft eine Gasturbine mit einem Bauteil der im Vorherigen und nachfolgend beschriebenen Art. Insbesondere ist das Bauteil in einem thermisch besonders beanspruchten Bereich der Gasturbine angeordnet. Der Faserverbundwerkstoff kann Teile des Bauteils und/oder der Gasturbine als Hitzeschild vor hohen Verbrennungstemperaturen schützen. Dank der hohen thermischen Belastbarkeit einer derartigen Gasturbine, beziehungsweise des Bauteils und des Faserverbundwerkstoffs ist es möglich, eine Verbrennungstemperatur der Gasturbine gegenüber dem Stand der Technik zu erhöhen. Beispielsweise kann die Verbrennungstemperatur der erfindungsgemäßen Gasturbine 1400°C, 1600°C oder mehr betragen. Aus der erhöhten Verbrennungstemperatur folgt nach den Gesetzen der Thermodynamik ein höherer Wirkungsgrad. Der höhere Wirkungsgrad wiederum zieht einen geringeren Schadstoffausstoß, insbesondere an CO₂, nach sich.

Ein weiterer Aspekt der Erfindung betrifft ein Verfahren zum Herstellen eines keramischen Faserverbundwerkstoffs, bei welchem keramische Fasern in eine keramische Matrix eingebettet werden, wobei zwischen den jeweiligen Fasern und der Matrix eine jeweilige Gleitschicht angeordnet wird. Erfindungsgemäß ist vorgesehen, dass die jeweilige Gleitschicht mittels Atomlagenabscheidung an der jeweiligen Faser angeordnet wird. Mit anderen Worten werden die Fasern der Matrix vor dem Einbetten derselben in die Matrix mittels Atomlagenbeschichtung mit der Gleitschicht versehen beziehungsweise beschichtet. Mit anderen Worten werden zunächst die keramischen Fasern mittels Atomlagenabscheidung mit einer jeweiligen Gleitschicht beschichtet und anschließend in die keramische Matrix eingebettet. Beim Anordnen der jeweiligen Gleitschicht mittels Atomlagenabscheidung kann die jeweilige Gleitschicht jeweils Atomlage für Atomlage auf die jeweilige Faser aufgebracht werden. Mit anderen Worten werden übereinander liegende Atomlagen der jeweiligen Gleitschicht jeweils unabhängig voneinander nacheinander auf die jeweilige Faser aufgebracht. Daraus resultiert eine im Vergleich zu anderen Herstellungsverfahren besonders dünne und defektarme Struktur der jeweiligen Gleitschicht. Daraus wiederum folgen besonders gute Gleiteigenschaften der Fasern in der Matrix. Außerdem ist durch den Prozess der Atomlagenabscheidung eine Dicke der Gleitschicht besonders gut kontrollierbar. Insbesondere kann die Schichtdicke besonders genau auf einen vorbestimmten Sollwert eingestellt werden. Zudem handelt es sich bei der Atomlagenabscheidung um ein besonders wirtschaftlich einsetzbares Herstellungsverfahren.

Das Prinzip der Atomlagenabscheidung ist aus dem Bereich der Halbleiterelektronik beziehungsweise Mikroelektronik zur Herstellung integrierter Schaltungen bekannt. Es handelt sich somit um ein Herstellungsverfahren, welches zwar grundsätzlich bekannt ist, jedoch vorliegend in einem stark unterschiedlichen Kontext eingesetzt wird. Das Prinzip der Atomlagenabscheidung wird im Englischen auch häufig mit dem Fachbegriff "Atomic Layer Deposition" oder kurz "ALD" bezeichnet.

Gemäß einer Weiterbildung ist vorgesehen, dass beim Anordnen der Gleitschicht Triisopropylborat mittels Atomlagenabscheidung auf die Faser aufgebracht wird und das Triisopropylborat anschließend, insbesondere durch Zugabe von Ammoniak, in hexagonales Bornitrid umgewandelt wird. Im Allgemeinen kann zunächst ein erster Precursor der Gleitschicht, im vorliegenden das Triisopropylborat, mittels Atomlagenabscheidung auf die Faser aufgebracht werden beziehungsweise die Faser wird mit dem ersten Precursor der Gleitschicht beschichtet. Anschließend kann der erste Precursor der Gleitschicht zusammen mit einem zweiten Precursor der Gleitschicht, vorliegend der Ammoniak, in ein Material der Gleitschicht, vorliegend das hexagonale Bornitrid, umgewandelt werden. Vorzugsweise handelt es sich bei dem ersten Precursor der Gleitschicht um einen Feststoff, welcher an der Oberfläche der jeweiligen Faser anhaftet. Vorzugsweise handelt es sich bei dem zweiten Precursor um eine Flüssigkeit oder nochmals bevorzugt um ein Gas. Zwischen dem Aufbringen des ersten Precursors der Gleitschicht und des zweiten Precursors der Gleitschicht kann ein Spülvorgang durchgeführt werden, um überschüssiges Material des ersten Precursors der Gleitschicht zu entfernen. Der Spülvorgang kann beispielsweise mit Stickstoff durchgeführt werden. Vorteile der alterierenden Zugabe des ersten Precursors der Gleitschicht und des zweiten Precursors der Gleitschicht liegen darin, dass keine chemische Reaktion zwischen den Precursoren in der Gasphase stattfindet. Die Entstehung von Nebenprodukten kann dadurch eingeschränkt werden. Außerdem folgt eine noch homogenere und konformere Beschichtung der Faser.

Gemäß einer Weiterbildung ist vorgesehen, dass nach dem Anordnen der jeweiligen Gleitschicht zusätzlich noch eine jeweilige Diffusionssperre auf der jeweiligen Gleitschicht gebildet wird. Mit anderen Worten wird nach dem Beschichten der jeweiligen Faser mit der Gleitschicht noch die jeweilige Gleitschicht mit der jeweiligen Diffusionssperre beschichtet. Auf diese Weise kann die Gleitschicht, insbesondere das hexagonale Bornitrid, vor der Oxidation durch ein Eindringen in Sauerstoff geschützt werden. Vorzugsweise wird die jeweilige Diffusionssperre mittels Atomlagenabscheidung an der Gleitschicht angeordnet. Mit anderen Worten wird die Gleitschicht vorteilhafterweise mittels Atomlagenabscheidung mit der Diffusionssperre beschichtet.

Gemäß einer Weiterbildung ist vorgesehen, dass die jeweilige Diffusionssperre auf der jeweiligen Gleitschicht gebildet wird, indem Trimethylaluminium mittels Atomlagenabscheidung auf die jeweilige Gleitschicht aufgebracht wird und das Trimethylaluminium anschließend, insbesondere durch Zugabe von Wasser oder Wasserdampf, in Aluminiumoxid umgewandelt wird. Im Allgemeinen wird somit zunächst ein erster Precursor der Diffusionssperre mittels Atomlagenabscheidung auf die jeweilige Gleitschicht aufgebracht beziehungsweise die jeweilige Gleitschicht zunächst mit dem ersten Precursor der Diffusionssperre beschichtet. Vorteilhafterweise handelt es sich bei der ersten Precursordiffusionssperre um einen Feststoff, der an der Oberfläche der Gleitschicht haftet. Anschließend kann der erste Precursor der Diffusionssperre durch Zugabe eines zweiten Precursors der Diffusionssperre, welcher vorzugsweise flüssig oder gasförmig ist, in das Material der Diffusionssperre überführt werden. Zwischen der Zugabe des ersten Precursors der Diffusionssperre und des Precursors der Diffusionssperre kann ein Spülvorgang, insbesondere mit Stickstoff, durchgeführt werden, um überschüssiges Material des ersten Precursors der Diffusionssperre zu entfernen.

Zusammengefasst kann das Verfahren derart weiterentwickelt werden, dass nach dem Anordnen der jeweiligen Gleitschicht eine jeweilige Diffusionssperre auf der jeweiligen Gleitschicht gebildet wird, indem Trimethylaluminium mittels Atomlagenabscheidung auf die jeweilige Gleitschicht aufgebracht wird und das Trimethylaluminium anschließend, insbesondere durch Zugabe von Wasser oder Wasserdampf, in Aluminiumoxid umgewandelt wird.

Vorteilhafte Weiterbildungen und deren Vorteile, die im Kontext des erfindungsgemäßen Faserverbundwerkstoffs, des erfindungsgemäßen Bauteils oder der erfindungsgemäßen Gasturbine offenbart wurden, gelten analog auch für das erfindungsgemäße Verfahren zum Herstellen des Faserverbundwerkstoffs. Umgekehrt gelten vorteilhafte Ausführungsformen, Weiterbildungen und deren Vorteile des erfindungsgemäßen Verfahrens auch für den erfindungsgemäßen Faserverbundwerkstoff, das erfindungsgemäße Bauteil und die erfindungsgemäße Gasturbine.

Weitere Merkmale und Vorteile sind der folgenden Beschreibung anhand der beigefügten Figuren zu entnehmen. In den Figuren bezeichnen gleiche Bezugszeichen gleiche Merkmale und Funktionen. Die Ausführungsbeispiele dienen lediglich der Erläuterung der Erfindung und sollen diese nicht beschränken.

Es zeigen:
- FIG 1: ausschnittsweise einen schematischen Querschnitt durch einen Faserverbundwerkstoff; und
- FIG 2: äußerst schematisch eine Gasturbine.

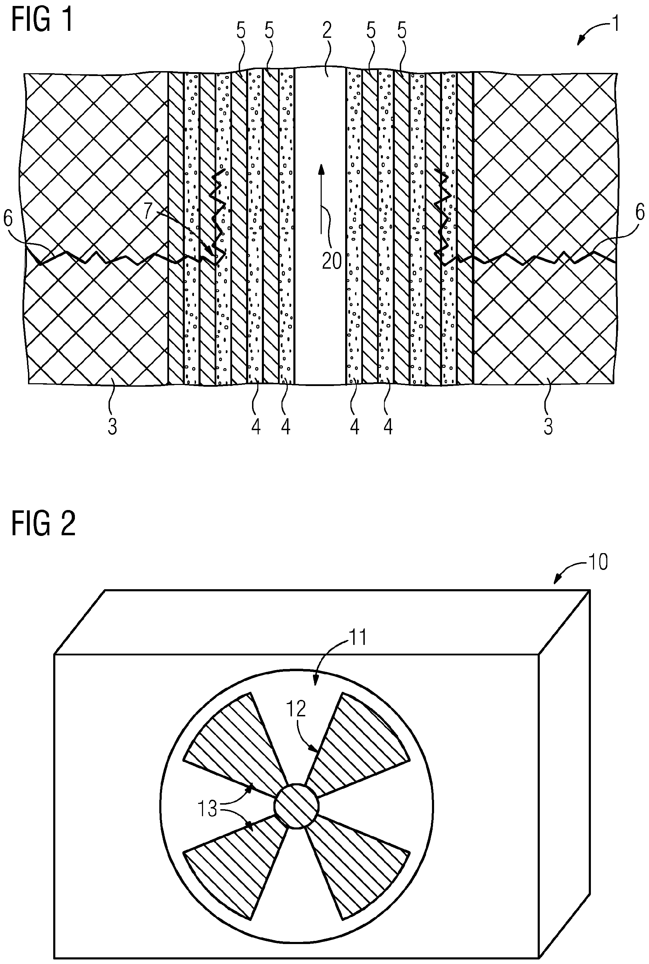

FIG 1 zeigt querschnittsweise einen Ausschnitt aus einem Faserverbundwerkstoff 1. Der Faserverbundwerkstoff 1 weist keramische Fasern 2 auf, wobei in der FIG 1 nur eine einzelne solche Faser 2 gezeigt ist. Die Fasern 2 sind eingebettet in eine keramische Matrix 3. Bei den Fasern 2 handelt es sich vorzugsweise um Mullit-Fasern. Mullit ist ein keramisches Material, welches sich im Wesentlichen aus Aluminiumoxid und Siliziumdioxid zusammensetzt. Die Faser 2 weist eine Erstreckungsrichtung 20 auf. Die kristalline Struktur innerhalb der Faser 2 ist derart gebildet, dass die Faser 2 entlang der Erstreckungsrichtung 20 eine gegenüber anderen Richtungen erhöhte Zugfestigkeit aufweist. Insbesondere weist die Faser 2 entlang der Erstreckungsrichtung 20 eine höhere Zugfestigkeit auf als polykristallines oder amorphes Mullit.

Die Matrix 3 kann zumindest aus Siliziumdioxid und/oder Aluminiumdioxid gebildet sein. Mit anderen Worten kann ein Materialmix der Matrix 3 Aluminiumdioxid, Siliziumdioxid oder sowohl Aluminiumdioxid als auch Siliziumdioxid umfassen. Je größer der Aluminiumdioxidanteil ist, desto günstiger kann die Matrix 3 herzustellen sein. Die Matrix 3 kann amorph oder polykristallin ausgeführt sein. Mit anderen Worten kann das Aluminiumdioxid und/oder das Siliziumdioxid in der Matrix 3 in amorphem oder polykristallinem Zustand vorliegen. In dem Faserverbundwerkstoff 1 weist die Faser 2 entlang ihrer Erstreckungsrichtung 20 eine größere Zugfestigkeit auf als die Matrix 3.

Die Faser 2 weist vorliegend eine Beschichtung auf. Im vorliegenden Ausführungsbeispiel ist die Faser 2 mit mehreren Gleitschichten 4 sowie mehreren Diffusionssperren 5 beschichtet. Die mehreren Gleitschichten 4 und Diffusionssperren 5 umschließen die Faser 2 jeweils zylindrisch mit jeweils zunehmendem Zylinderradius. Direkt an der Faser 2 ist eine der Gleitschichten 4 angeordnet. Mit anderen Worten berührt die Faser 2 eine der Gleitschichten 4. Diese der Gleitschichten 4 ist wiederum mit einer der Diffusionssperren 5 beschichtet. Wie in der FIG 1 zu erkennen ist, folgen zwischen der Faser 2 und der Matrix 3 mehrere Gleitschichten 4 und Diffusionssperren 5 abwechselnd aufeinander. Benachbarte Gleitschichten 4 und Diffusionssperren 5 berühren sich dabei jeweils und können vorzugsweise stoffschlüssig miteinander verbunden sein. Vorteilhafterweise ist eine der Gleitschichten 4 direkt an der Faser 2 angeordnet und vorteilhafterweise stoffschlüssig mit dieser verbunden. Ausgehend von der Faser 2 ist als letzte Schicht vorzugsweise eine Diffusionssperre 5 angeordnet.

Mit anderen Worten kann eine äußerste der Diffusionssperren 5 die Matrix 3 berühren.

Vorliegend in der FIG 1 ein Beispiel mit mehreren Gleitschichten 4 und Diffusionssperren 5 gezeigt. Selbstverständlich kann in einer anderen, in den FIG nicht gezeigten Ausführungsform auch nur jeweils eine einzige Gleitschicht 4 und eine einzige Diffusionssperren 5 an jeder Faser 2 vorgesehen sein. Insbesondere ist die jeweilige Faser 2 durch die jeweilige Gleitschicht 4 und die jeweilige Diffusionssperre 5 zylindrisch umschlossen. Aus Gründen der Einfachheit ist im Folgenden nur noch von der Gleitschicht 4 und der Diffusionssperre 5 die Rede, wobei selbstverständlich jeweils auch jede der Diffusionssperren 5 und jede der Gleitschichten 4 gemeint ist.

Die Gleitschicht 4 ist mittels Atomlagenabscheidung an der Faser 2 angeordnet. Mit anderen Worten ist die Faser 2 mittels Atomlagenabscheidung mit der Gleitschicht 4 beschichtet. Eine solche mittels Atomlagenabscheidung angeordnete Gleitschicht 4 zeichnet sich durch eine besonders wohldefinierte und kontrollierbare Schichtdicke, eine erhöhte Schichtreinheit, und eine besonders homogene und konforme Beschichtung jeweils verglichen mit anderen Beschichtungsverfahren aus.

Vorliegend ist die Diffusionssperre 5 durch Beschichtung mittels Atomlagenabscheidung an der Faser beziehungsweise der jeweils zylindrisch innenliegenden Gleitschicht 4 angeordnet. Mit anderen Worten ist die jeweilige, zylindrisch betrachtet innenliegende Gleitschicht 4 mittels Atomlagenabscheidung mit der jeweiligen Diffusionssperre 5 beschichtet. Für die mittels Atomlagenbeschichtung angeordnete Diffusionssperre 5 gelten die Vorteile der mittels Atomlagenbeschichtung angeordneten Gleitschicht 4 analog. Die Diffusionssperre 5 ist vorliegend zumindest aus Aluminiumoxid gebildet. Mit anderen Worten kann die Diffusionssperre 5 vollständig aus Aluminiumoxid oder aus einer Materialmischung, welche Aluminiumoxid umfasst, bestehen.

Vorliegend ist die Gleitschicht 4 zumindest aus Bornitrid (BN), insbesondere hexagonalem Bornitrid, gebildet. Mit anderen Worten kann die Gleitschicht 4 vollständig aus Bornitrid, insbesondere hexagonalem Bornitrid, oder aus einer Materialmischung, welche Bornitrid, insbesondere hexagonales Bornitrid, und zumindest ein weiteres Material umfasst, gebildet sein.

Da Bornitrid, insbesondere hexagonales Bornitrid, bei hohen Temperaturen unter Einfluss von Sauerstoff zu Bortriooxid B₂O₃ oxidiert, ist ein Schutz der Gleitschicht 4 vor eindringendem Sauerstoff nötig. Dieser Schutz wird durch die Diffusionssperre 5 bereitgestellt. Diese Diffusionssperre 5 verhindert das Eindringen von Sauerstoff in die Gleitschicht 4. Die Diffusionssperre 5 schützt Faser 2 und Gleitschicht 4 vor Oxidation.

Die Gleitschicht 4 ermöglicht insbesondere ein Gleiten der Faser 2 relativ zur Matrix 3. Mit anderen Worten ermöglicht die Gleitschicht 4 eine Relativbewegung zwischen Faser 2 und Matrix 3. Auf diese Weise kann eine Krafteinleitung in den Faserverbundwerkstoff verbessert werden. Eine Rissbildung an der Faser 2 kann durch dieses Gleiten vermieden werden. Ohne die Gleitschicht 4 beziehungsweise ohne die Möglichkeit der Faser 2 relativ zu der Matrix 3 zu gleiten, würde ein Riss 6 in der Matrix 3 direkt an die Faser 2 weitergegeben werden und diese ebenfalls zum Reißen bringen. Der Faserverbundwerkstoff würde versagen. In diesem Fall würde sich der Faserverbundwerkstoff 1 wie eine unverstärkte Keramik verhalten und ein Sprödbruchverhalten zeigen. Die Gleitschicht 4 ermöglicht vorliegend jedoch ein Gleiten der Faser 2, was zu einer Rissablenkung 7 führt. Die Rissablenkung 7 wiederum ermöglicht eine verbesserte Krafteinleitung in die Faser 2, was ein Reißen der Faser 2 verhindert. In der Folge wird das Faserverbundmaterial weiter durch die Faser 2 zusammengehalten, wodurch die thermische und/oder mechanische Belastbarkeit des Faserverbundwerkstoffs 1 insgesamt erhöht wird. Der Riss 6 kann die Folge einer mechanischen oder thermischen (Temperaturschock) Belastung sein.

Durch die Schichtstruktur mit der Gleitschicht wird der Riss 6 in der Matrix 3 parallel zur Faser 2 abgelenkt und verzweigt. Dabei wird eine Rissenergie abgebaut.

Noch besser geeignet zum Abbau der Rissenergie ist ein Multilagensystem mit mehreren Gleitschichten 4 und mehreren Diffusionssperren 5, wie in FIG 1 gezeigt. Tritt bei einem solchen Multilagensystem der Riss 6 auf, so werden üblicherweise nicht alle Diffusionssperren 5 und Gleitschichten 4 durch den Riss 6 beziehungsweise die Rissablenkung 7 verletzt. Durch den Riss 6 können einzelne der Gleitschichten 4 durch eindringenden Sauerstoff oxidiert werden. Weiter innenliegende der Gleitschichten 4 und Diffusionssperren 5 bleiben jedoch unbeschädigt. Somit bleibt die Gleitfunktion der innenliegenden, unbeschädigten Gleitschichten 4 und der Oxidationsschutz durch die innenliegenden, unbeschädigten Diffusionssperren 5 gewährleistet. Somit bleibt die vergleichsweise hohe mechanische und thermische Belastbarkeit des Faserverbundwerkstoffs 1 auch nach Auftreten des Risses 6 erhalten.

Zur Herstellung des Faserverbundwerkstoffs 1 wird zunächst hexagonales Bornitrid mittels Atomlagenabscheidung auf die Faser aufgebracht. Anschließend wird eine Umgebung der Faser 2 evakuiert und mit dem Stickstoff gespült, um überschüssiges Triisopropylborat zu entfernen. Als nächstes wird Ammoniakgas eingeleitet, um das Triisopropylborat an der Faser 2 in Bornitrid, insbesondere hexagonales Bornitrid, umzuwandeln. Dabei entsteht außerdem Isopropylalkohol. Daher wird die Umgebung um die Faser 2 erneut evakuiert und mit Stickstoff gespült, um überschüssiges Ammoniak und Isopropylalkohol zu entfernen. Es ist somit eine erste Gleitschicht 4 auf der Faser 2 entstanden.

Anschließend wird auf diese erste Gleitschicht 4 Trimethylaluminium mittels Atomlagenabscheidung aufgebracht.

Anschließend erfolgt wieder ein Evakuierungs- und Spülvorgang mit Stickstoff, um überschüssiges Trimethylaluminium zu entfernen. Durch das Einleiten von Wasser-Gas beziehungsweise Wasserdampf wird das Trimethylaluminium in Aluminiumoxid umgewandelt. Dabei entsteht außerdem Methan. Durch erneutes Evakuieren und Spülen mit Stickstoff kann überschüssiges Wasser-Gas beziehungsweise Wasserdampf und das Methan entfernt werden.

Anschließend kann wiederum mittels Atomlagenabscheidung das Triisopropylborat auf die Diffusionssperre 5 aufgebracht werden. Vorzugsweise werden die vorherig genannten Schritte mehrfach durchlaufen, um nacheinander die abwechselnden Schichten aus mehreren Gleitschichten 4 und mehreren Diffusionssperren 5 an der Faser 2 anzuordnen.

Alternative Precursor zum Herstellen der Gleitschicht 4 aus hexagonalem Bornitrid sind Trimethylborat, Triethylboran und Trisethylmethylaminoborane.

Alternative erste Precursor der Gleitschicht 4 zum Herstellen der Gleitschicht 4 sind Trimethylborat, Triethylboran und Trisethylmethylaminoborane. Im Falle der Trisethylmethylaminoborane kann eine plasmaunterstützte Atomlagenabscheidung erforderlich sein.

FIG 2 zeigt beispielhaft und äußerst schematisch eine Gasturbine 10. Die Gasturbine 10 weist ein Bauteil 11 auf, welches einen Trägerkörper 12 aus einer metallischen Legierung und ein Hitzeschild 13 umfasst. Der Faserverbundwerkstoff 1 beziehungsweise der Hitzeschild 13 sind dazu ausgebildet, den Trägerkörper 12 vor einer thermischen Belastung durch eine Verbrennung von Brennstoff in der Gasturbine 10 zu schützen. Dank des Hitzeschilds 13 ist ein Betrieb der Gasturbine 10 bei einer Verbrennungstemperatur von mehr 1400° Celsius, mehr 1600°C oder mehr möglich, was gegenüber einer geringeren Verbrennungstemperatur einen höheren Wirkungsgrad ermöglicht. Durch den höheren Wirkungsgrad kann ein Schadstoffausstoß der Gasturbine 10 verringert werden. Außerdem ist der Betrieb der Gasturbine 10 im Vergleich zu einer Gasturbine mit geringerem Wirkungsgrad effizienter und kostengünstiger.

Bei dem vorliegenden Herstellungsverfahren lassen sich die Fasern 2 kostengünstig und sauber aus der Gasphase über geeignete Precursoren beschichten. Die Fasern 2 lassen sich in einem Prozessablauf versehen mit der Beschichtung gemäß dem Multilagensystem, insbesondere ohne dass die Faser eine Beschichtungsanlage zwischenzeitlich verlassen muss. Der Beschichtungsaufwand kann hierdurch relativ gering gehalten werden. Außerdem werden die Fasern 2, insbesondere Mullit-Fasern, durch die Diffusionssperre 5 vor oxidativem und korrosivem Angriff geschützt, was im Falle einer Mullit-Faser in einer porösen Mullit-Matrix nicht gewährleistet ist.

Ist die äußerste Schicht der Beschichtung der Faser 2 eine Diffusionssperre 5, so steht diese bei hohen Temperaturen mit der Matrix 3 in einem Gleichgewicht, wenn die Matrix 3 ebenfalls aus Aluminiumoxid ist. In diesem Fall können zwischen Diffusionssperre 5 und Matrix 3 keine Reaktionen stattfinden. Im Allgemeinen befindet sich die Matrix 3, wenn diese aus Aluminiumoxid besteht, mit der äußersten Diffusionssperre 5 im Gleichgewicht. Durch das Multilagensystem gemäß FIG 1 kann zudem eine Bruchdehnung und das Herausziehen der Faser 2 verzögert werden. Aufgrund des abwechselnden Schichtaufbaus zwischen den Gleitschichten 4 und den Diffusionssperren 5 wird im Falle des Risses 6 nur ein Teil der Beschichtung der Faser 2 beschädigt. Der unverletzte Teil der Beschichtung der Faser 2 kann nach der Rissablenkung 7 die Gleitfunktion und den Oxidationsschutz aufrechterhalten. Die Lebensdauer des Faserverbundwerkstoffs 1 und des Bauteils 11 verlängert sich hierdurch. Somit sind weniger Instandhaltungszyklen bei der Gasturbine 10 erforderlich.

Die Diffusionssperre 5 schützt die Faser 2 bei Verwendung die Gasturbine 10 nicht nur vor Sauerstoff, sondern auch vor Wasser, das dem Brennstoff zum Betrieb der Gasturbine 10 zugespritzt wird. Der Wasserdampf kann das Siliziumdioxid einer als Mullit-Faser ausgebildeten Faser angreifen und zu einem Materialabtrag aus der Faser 2 führen. Hierdurch könnte das Gefüge der Faser 2 gestört werden. Dies wird jedoch durch die Diffusionssperre 5 verhindert.

Bauteile der Gasturbine 10, welche mittels eines Hitzeschilds 13 aus dem Faserverbundwerkstoff 1 geschützt werden können, sind beispielsweise Brennkammer, Übergangskanäle, Leitschaufeln und Ringsegmente. Außerdem ist im Betrieb einer solchen Gasturbine 10 auch der Einsatz wasserstoffreichen Brennstoffs beziehungsweise Brenngases möglich, weil der Verbund aus Faser 2 und Diffusionssperre 5 das Bauteil 11 der Gasturbine 10 vor Korrosion durch Wasser schützt, welches aufgrund der hohen Flammgeschwindigkeit und des Flammenrückschlags des Wasserstoffs zugespritzt wird.

Dank der thermischen Belastbarkeit des Faserverbundwerkstoffs 1 beziehungsweise des Hitzeschilds 13 kann eine Filmkühlung von Brennkammerelementen der Gasturbine 10 gegenüber dem Stand der Technik verringert werden oder ganz darauf verzichtet werden. Filmkühlung bedeutet, dass durch Bohrungen in der metallischen Auskleidung der Brennkammer kühle, nicht verbrannte Luft eingeblasen wird. Diese kühle Luft mischt sich mit dem heißen Gas. Die Temperatur sinkt und bei der Verbrennung entstehen unerwünschte Nebenprodukte wie Kohlenmonoxid und unverbrannte Kohlenwasserstoffe. Zum anderen erfolgt durch die zugeführte Luft eine Verbrennung des verblendeten Brennstoff-Luft-Gemischs. Das bedeutet, das Gemisch ist magerer geworden, weil mehr Stickstoff und Sauerstoff vorhanden sind. Folglich werden mehr schädliche Stickoxide gebildet. Dank der hohen thermischen Belastbarkeit und einer verbesserten Temperaturisolation der Gasturbine 10 durch den Faserverbundwerkstoff 1 beziehungsweise das Hitzeschild 13 ermöglicht den Verzicht beziehungsweise die Herabsetzung der Filmkühlung und somit eine niedrigere Schadstoffemission. Durch einen geringeren Kühlbedarf der Gasturbine 10 allgemein können weniger Durchlässe für Kühlfluid nötig sein. Hierdurch werden die Kosten für die Herstellung der Gasturbine 10 gesenkt und/oder der Wirkungsgrad der Gasturbine 10 weiter erhöht.

## Patentansprüche

1. Faserverbundwerkstoff (1) mit keramischen Fasern (2) und einer keramischen Matrix (3), in welche die Fasern (2) eingebettet sind, wobei zwischen den jeweiligen Fasern (2) und der Matrix (3) eine jeweilige Gleitschicht (4) angeordnet ist, **dadurch gekennzeichnet, dass**
die jeweilige Gleitschicht (4) mittels Atomlagenabscheidung an der jeweiligen Faser (2) angeordnet ist.

2. Faserverbundwerkstoff (1) nach Anspruch 1, **dadurch gekennzeichnet, dass** zwischen der jeweiligen Gleitschicht (4) und der Matrix (3) zusätzlich eine jeweilige Diffusionssperre (5) angeordnet ist.

3. Faserverbundwerkstoff (1) nach Anspruch 2, **dadurch gekennzeichnet, dass** die Diffusionssperre (5) mittels Atomlagenabscheidung auf die Gleitschicht (4) aufgebracht ist.

4. Faserverbundwerkstoff (1) nach Anspruch 2 oder 3, **dadurch gekennzeichnet, dass** die Diffusionssperre (5) zumindest aus Aluminiumoxid gebildet ist.

5. Faserverbundwerkstoff (1) nach einem der vorhergehenden Ansprüche, **dadurch gekennzeichnet, dass** die Gleitschicht (4) zumindest aus hexagonalem Bornitrid gebildet ist.

6. Faserverbundwerkstoff (1) nach einem der vorhergehenden Ansprüche, **dadurch gekennzeichnet, dass** die Fasern (2) zumindest aus Mullit gefertigt sind.

7. Faserverbundwerkstoff (1) nach einem der vorhergehenden Ansprüche, **dadurch gekennzeichnet, dass** die Matrix (3) aus Siliziumdioxid und/oder Aluminiumdioxid gebildet ist.

8. Faserverbundwerkstoff (1) nach einem der vorhergehenden Ansprüche, **dadurch gekennzeichnet, dass** zwischen der jeweiligen Faser (2) und der Matrix (3) abwechselnd mehrere Gleitschichten (4) und mehrere Diffusionssperren (5) angeordnet sind.

9. Bauteil (11), welches zumindest aus einem Faserverbundwerkstoff (1) nach einem der vorhergehenden Ansprüche gebildet ist.

10. Bauteil (11) nach Anspruch 9, **dadurch gekennzeichnet, dass** das Bauteil (11) wenigstens einen Trägerkörper (1) aufweist, welcher zumindest teilweise mit dem Faserverbundwerkstoff als Hitzeschild versehen ist.

11. Bauteil nach Anspruch 9 oder 10, **dadurch gekennzeichnet, dass** der Trägerkörper (12) aus einem von dem Faserverbundwerkstoff (1) unterschiedlichen Werkstoff, insbesondere aus einem metallischen Werkstoff, gebildet ist.

12. Gasturbine (10) mit einem Bauteil (11) nach einem der Ansprüche 9 bis 11.

13. Verfahren zum Herstellen eines keramischen Faserverbundwerkstoffs (1), bei welchem keramische Fasern (2) in eine keramische Matrix (3) eingebettet werden, wobei zwischen den jeweiligen Fasern (2) und der Matrix (3) eine jeweilige Gleitschicht (4) angeordnet wird,
**dadurch gekennzeichnet, dass**
die jeweilige Gleitschicht (4) mittels Atomlagenabscheidung an der jeweiligen Faser (2) angeordnet wird.

14. Verfahren nach Anspruch 13, **dadurch gekennzeichnet, dass** beim Anordnen der Gleitschicht (4) Triisopropylborat mittels Atomlagenabscheidung auf die Faser (2) aufgebracht wird und das Triisopropylborat anschließend, insbesondere durch Zugabe von Ammoniak, in hexagonales Bornitrid umgewandelt wird.

15. Verfahren nach Anspruch 13 oder 14, **dadurch gekennzeichnet, dass** nach dem Anordnen der jeweiligen Gleitschicht (4) eine jeweilige Diffusionssperre (5) auf der jeweiligen Gleitschicht (4) gebildet wird, indem Trimethylaluminium mittels Atomlagenabscheidung auf die jeweilige Gleitschicht (4) aufgebracht wird und das Trimethylaluminium anschließend, insbesondere durch Zugabe von Wasser oder Wasserdampf, in Aluminiumoxid umgewandelt wird.
